# EUROPEAN PATENT APPLICATION

(11) **EP 2 451 014 A1**
(43) Date of publication of application: **09.05.2012**
(21) Application number: 10794233.6
(22) Date of filing: 01.07.2010
(51) Int. Cl.: H01R 11/01, H01B 5/00, H01B 13/00

(54) **COATED CONDUCTIVE PARTICLES AND METHOD FOR PRODUCING SAME**

(30) Priority: 01.07.2009 JP 2009157189
(71) Applicant: Hitachi Chemical Company, Ltd., Tokyo 163-0449 (JP)
(72) Inventor: TAKAI Kenji, Tsukuba-shi Ibaraki 300-4247 (JP); EJIRI Yoshinori, Chikusei-shi Ibaraki 308-8521 (JP); NAGAHARA Yuuko, Tsukuba-shi Ibaraki 300-4247 (JP); MATSUZAWA Mitsuharu, Tsukuba-shi Ibaraki 300-4247 (JP)
(74) Representative: HOFFMANN EITLE
(86) International application number: PCT/JP2010/061267
(87) International publication number: WO 2011/002065

(57) **Abstract**

[Problem to be Solved] To provide conductive particles which are capable of providing an anisotropically conductive adhesive that can maintain sufficient insulation characteristics and conduction characteristics even when used for the connection of a very small circuit, while having excellent moisture absorption resistance at a lower cost.

[Solution] A coated conductive particle (5) comprises: a composite conductive particle (3) that has a resin particle (4) and a metal layer (6) that covers the resin particle (4); and insulating fine particles (1) that are provided on the outer side of the metal layer (6) so as to partially cover the surface of the metal layer (6). The metal layer (6) has a nickel-palladium alloy plating layer (6a).

## Description

### Technical Field

The present invention relates to coated conductive particles and a method for producing the same.

### Background Art

Methods for mounting a liquid crystal driver IC on a liquid crystal display glass panel are classified roughly into two types: COG (Chip-on-Glass) mounting and COF (Chip-on-Flex) mounting. In the COG mounting, a liquid crystal IC is directly bonded on a glass panel using an anisotropically conductive adhesive containing conductive particles. By contrast, in the COF mounting, a liquid crystal driver IC is bonded to a flexible tape having metal wiring, and then they are bonded to a glass panel using an anisotropically conductive adhesive containing conductive particles. The term "anisotropically" herein means having electrical conductivity in a pressurized direction and maintaining electrical insulation in a non-pressurized direction.

With the recent advent of high-definition liquid crystal displays, however, gold bumps acting as circuit electrodes for a liquid crystal driver IC have narrower pitches therebetween and smaller areas. This may cause a problem that conductive particles in an anisotropically conductive adhesive flow out between adjacent circuit electrodes to cause a short circuiting. Especially in the COG mounting, such a tendency is remarkable. Additionally, when conductive particles flow out between adjacent circuit electrodes, such a problem also arises that the number of conductive particles supplemented between gold bumps and a glass panel is reduced, a connection resistance between circuit electrodes facing each other increases, and thus a disconnection occurs therebetween.

Thus, as solutions to solve these problems, Patent Literature 1 suggests a method in which an insulating adhesive is provided on at least one surface of an anisotropically conductive adhesive layer to prevent a deterioration in bonding quality in the COG mounting or COF mounting. Patent Literature 2 suggests a method in which the entire surface of a conductive particle is coated with an insulating coat. Additionally, Patent Literatures 3 and 4 also suggest a method in which a surface of a conductive particle is coated with insulating fine particles.

Patent Literature 5 discloses a method in which a resin fine particle is plated with copper/gold as an attempt to enhance conductivity of a conductive particle. Patent Literature 6 discloses a conductive particle comprising a nickel layer coating a metal layer containing copper in an amount of 50% by mass or more, and a gold layer. Patent Literature 7 discloses a metal coating particle in which a content of gold in a metal coating layer is 90% by mass or more.

### Citation List

### Patent Literature

Patent Literature 1: Japanese Patent Application Laid-Open No. 8-279371
Patent Literature 2: Japanese Patent No. 2794009
Patent Literature 3: Japanese Patent No. 2748705
Patent Literature 4: International Publication No. WO 2003/02955
Patent Literature 5: Japanese Patent Application Laid-Open No. 2006-28438
Patent Literature 6: Japanese Patent Application Laid-Open No. 2001-155539
Patent Literature 7: Japanese Patent Application Laid-Open No. 2005-36265

### Summary of Invention

### Technical Problem

In a method in which an insulating adhesive is provided on one surface of a circuit connecting member, when a very small circuit, in which an area of a bump is, for example, smaller than 3000 µm², is connected, there is still room for improvement in an electrical insulation between adjacent electrodes and conductivity between electrodes connected.

Meanwhile, a type of a conductive particle prepared by plating a nickel layer with gold, which has become a mainstream recently, has a problem in that nickel is released to migrate. When the thickness of the gold-plated layer is set to 400 Å or smaller, this tendency is significant. A metal coating particle containing a lot of gold in a coating layer is good in terms of reliability, but incur a high cost and is not so practically applicable because a content of gold tends to be lowered recently. A copper plating particle is good in terms of conductivity and cost, but has a problem in moisture absorption resistance because migration tends to occur. Attempts to compensate for the disadvantages of the both (gold and copper) have therefore been made, but a sufficiently satisfactory level has not yet been attained. A silver plating particle is more readily migrate than copper. Additionally, nickel is a ferromagnetic material and thus, when only nickel is used, conductive particles are readily agglomerated magnetically. When a content proportion of phosphorus, etc., in nickel is increased for suppressing the magnetic agglomeration, the magnetic agglomeration can be relaxed but conduction characteristics of the conductive particle become poor.

Thus, an object of the present invention is to provide, at a lower cost, conductive particles which are capable of providing an anisotropically conductive adhesive that can maintain sufficient insulation characteristics and conduction characteristics even when used for the connection of a very small circuit, while having excellent moisture absorption resistance.

### Solution to Problem

The present invention relates to a coated conductive particle comprising: a composite conductive particle comprising a resin particle and a metal layer coating the resin particle; and insulating fine particles provided on the outer side of the metal layer and coating a part of a surface of the metal layer. In the coated conductive particle of the present invention, the metal layer comprises a nickel-palladium alloy plating layer.

The coated conductive particle of the present invention can provide an anisotropically conductive adhesive that can maintain sufficient insulation characteristics and conduction characteristics even when used for the connection of a very small circuit, while having excellent moisture absorption resistance.

It is preferred that a molar ratio of nickel:palladium in the nickel-palladium alloy plating layer is 1:99 to 99:1.

The nickel-palladium alloy plating layer can be comprised of a plurality of layers having different palladium proportions from each other. In this instance, it is preferred that an outermost layer in the plurality of layers has the largest amount of palladium. This can provide coated conductive particles having good properties at a lower cost while suppressing an amount of palladium used to the minimum.

The above metal layer can further comprise a gold plating layer or palladium plating layer provided on the outer side of the nickel-palladium alloy plating layer. In this instance, the insulating fine particles are provided on the outer side of the gold plating layer or palladium plating layer.

It is preferred that the insulating fine particles dent into the metal layer when an anisotropically conductive adhesive film containing the coated conductive particle is pressure bonded. Better conductivity is achieved due to the denting of the insulating fine particles into the metal layer. Ductility of the metal layer is thus extremely important.

It is preferred that the gold plating layer or palladium plating layer is a reduction plating type layer positioned at the outermost layer of the metal layer.

It is preferred that the nickel-palladium alloy plating layer contains boron or phosphorus.

In another aspect, the present invention relates to a method for producing a coated conductive particle. The production method of the present invention comprises the steps of: treating a composite conductive particle comprising a resin particle and a metal layer coating the resin particle wherein the metal layer comprising a nickel-palladium alloy plating layer, with a compound having a mercapto group, a sulfide group or a disulfide group to introduce a functional group on a surface of the metal layer; and providing insulating fine particles coating a part of the surface of the metal layer on the outer side of the composite conductive particle. Alternatively, the production method of the present invention comprising the steps of: treating a composite conductive particle comprising a resin particle and a metal layer coating the resin particle, the metal layer comprising a nickel-palladium alloy plating layer, with a compound having a mercapto group, a sulfide group or a disulfide group to introduce a functional group in a surface of the metal layer; forming a polymer electrolyte layer on the metal layer; and providing insulating fine particles coating a part of the surface of the metal layer, on the outer side of the composite conductive particle so that the polymer electrolyte layer is sandwiched therebetween.

The above production method of the present invention can provide, at a lower cost, coated conductive particles which can provide an anisotropically conductive adhesive that can maintain sufficient insulation characteristics and conduction characteristics even when used for the connection of a very small circuit, while having excellent moisture absorption resistance. A mercapto group, a sulfide group or a disulfide group can form a strong bond with a metal layer containing a noble metal such as palladium by a coordinate bond.

It is preferred that the functional group introduced on the surface of the metal layer is at least one selected from the group consisting of a hydroxyl group, a carboxyl group, an alkoxyl group and an alkoxycarbonyl group.

It is preferred that the polymer electrolyte layer is formed from polyamine. The polyamine is preferably polyethyleneimine.

It is preferred that the insulating fine particles are inorganic oxide particles. The inorganic oxide particles are preferably silica particles.

### Advantageous Effects of Invention

The present invention can provide, at a lower cost, coated conductive particles which can provide an anisotropically conductive adhesive that can maintain sufficient insulation characteristics and conduction characteristics even when used for the connection of a very small circuit, while having excellent moisture absorption resistance.

The production method of the present invention does not always need to modify a surface of the insulating fine particle with a functional group such as an isocyanate group and can avoid a problem of an agglomeration of the insulating fine particles at the modification step.

Additionally, according to the present invention, composite conductive particles can be stably coated with insulating fine particles in an appropriate coverage with small variations in coverage by the insulating fine particles between the composite conductive particles.

### Brief Description of Drawings

[Figure 1] Figure 1 is a cross-sectional view showing one embodiment of the coated conductive particle.
[Figure 2] Figure 2 is a cross-sectional view showing one embodiment of the anisotropically conductive adhesive.
[Figure 3] Figure 3 is a cross-sectional view showing one embodiment of a circuit connection method by the anisotropically conductive adhesive.
[Figure 4] Figure 4 is a cross-sectional view showing one embodiment of a circuit connection structure.

### Description of Embodiments

Preferred embodiments of the present invention will now be described in detail. The present invention, however, is not limited to these embodiments.

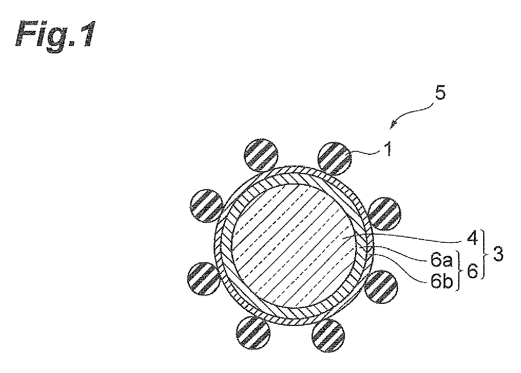

Figure 1 is a cross-sectional view showing one embodiment of the coated conductive particle. The coated conductive particle 5 of the present embodiment comprises: a composite conductive particle 3 that has a resin particle 4 and a metal layer 6 that coats the resin particle 4; and a plurality of insulating fine particles 1 which are provided on the outer side of the metal layer 6. The insulating fine particles 1 partially coat a surface of the metal layer 6. The metal layer 6 is constituted of a nickel-palladium alloy plating layer 6a, which directly coats the resin particle 4, and a gold plating layer or palladium plating layer 6b which coats the nickel-palladium alloy plating layer 6a. The gold plating layer or palladium plating layer 6b cannot be necessarily provided.

It is necessary for the particle diameter of the composite conductive particle 3 to be smaller than the minimum value of a distance between electrodes of circuit members to be connected. If electrodes to be connected have different heights, it is preferred that the particle diameter of the composite conductive particle 3 is larger than differences between the heights. From this viewpoint, the particle diameter of the composite conductive particle 3 is preferably 1 to 10 µm, more preferably 1 to 5 µm, and particularly preferably 2 to 3.5 µ m. The particle diameter of the composite conductive particle can be measured by BET method or scanning electron microscope (SEM). The particle diameter of the composite conductive particle in the anisotropically conductive adhesive film can be measured by SEM after dissolving and removing an adhesive composition by a solvent.

A resin forming the resin particle 4 is not particularly restricted, but the resin particle 4 contains a resin selected from acrylic resins such as polymethylmethacrylate and polymethylacrylate, and, polyolefin resins such as polyethylene, polypropylene, polyisobutylene and polybutadiene, and polystyrene resins.

Nickel is cheap but forms a thick oxide film and thus a metal layer formed from only nickel has problems that the insulating fine particles adhered are readily desorbed, a migration resistance is not prefect, a ductility is poor, it is likely to cause a magnetic agglomeration, and a contact resistance with a metal is high. Meanwhile, palladium is expensive and softish. Use of an alloy containing both can provide a composite conductive particle which is cheap, good in migration resistance, hard and ductile, and has a high adsorption strength to the insulating fine particle and a low contact resistance with metal.

A molar ratio of nickel:palladium in the nickel-palladium alloy plating layer is preferably from 1:99 to 99:1, more preferably from 1:9 to 9:1. For a single layer, it is preferably from 1:9 to 9:1, more preferably from 1:9 to 5.5. After preparing the conductive particle, the molar ratio can be calculated by an atomic absorption method.

It is preferred that the inner portion of the metal layer 7 is rich in nickel and the outer portion thereof is rich in palladium. When the outer portion is rich in palladium, a particle, in which an adsorption strength of the insulating fine particle is high and a contact resistance with a metal is low, can be produced. When the inner portion is rich in nickel, a particle, which is hard and has a good ductility as a whole, can be produced. Specifically, a molar ratio of nickel:palladium in the inner portion is preferably about from 99:1 to 1:1, and a molar ratio of nickel:palladium in the outer portion is preferably about from 1:99 to 1:1. The molar ratio of nickel:palladium in the inner portion is more preferably about from 99:1 to 9:1, and the molar ratio of nickel:palladium in the outer portion is more preferably about from 1:99 to 1:9.

Nickel has a ferromagnetism, and thus it is preferred that the magnetism is decreased by causing boron or phosphorus to be contained in the nickel-palladium alloy. For phosphorus, the magnetism approximately disappears by adding phosphorus in an amount of 10 mol % relative to a total number of moles of nickel and palladium, but a conductivity is also decreased, and thus phosphorus is added in an amount of preferably from 1 to 10 mol %, more preferably from 1 to 7 mol %, further preferably from 2 to 5 mol %.

The thickness of the nickel-palladium alloy plating layer is preferably 200 Å or larger and 2000 Å or smaller, more preferably 200 Å or larger and 1000 Å or smaller, further more preferably 300 Å or larger and 700 Å or smaller. A conductivity tends to decrease when the thickness of the nickel-palladium alloy plating layer is smaller than 200 Å, and a production cost tends to increase when the thickness of the nickel-palladium alloy plating layer is larger than 1000 Å.

As a method for forming the nickel-palladium alloy plating layer, an electroless nickel-palladium alloy plating is preferred. A palladium ion, which is a metal source for an electroless nickel-palladium plating bath, can be obtained by dissolving a palladium salt generally used (e.g. palladium sulfate, palladium nitrate, and palladium chloride) in water. The concentration of palladium in the electroless nickel-palladium plating bath is not particularly limited, but is usually about from 0.0001 to 1 mol/l. More preferably, the concentration is from 0.1 to 0.9 mol/l.

A nickel ion, which is another metal source, can be obtained by dissolving a nickel salt generally used (e.g. nickel sulfate, nickel nitrate, and nickel chloride) in water. The concentration of nickel in the electroless nickel-palladium plating bath is not particularly limited, but is usually about from 0.0001 to 1 mol/l. More preferably, the concentration is from 0.1 to 0.9 mol/l.

A reducing agent used can include a hypophosphoric acid compound, a borohydride compound, hydrazine and the like. Among them, a plating bath containing a hypophosphoric acid compound is good in stability and thus preferable.

When a hypophosphoric acid compound is used as the reducing agent, it is preferred that a pH adjusting agent and an ammonia complexing agent are used.

A formulation ratio of the above medical agents should be determined in consideration of a kind of a core material and a plating speed, but in many cases (Ni+Pd) : (ammonia complexing agent) : (hypophosphoric acid compound) is a molar ratio of preferably 1: from 1 to 5: from 1 to 3, more preferably 1: 2: 2.

A plating solution can be used by dipping as usual means, but preferably by a dropwise addition.

One example of the dropwise addition can include a method in which a liquid obtained by adding ammonia to nickel sulfate and palladium sulfate is added dropwise into a mother liquor containing sodium hypophosphite and sodium hydroxide. In this instance, a metal composition of the alloy plating layer can be controlled based on a ratio of nickel sulfate and palladium sulfate to be added.

The nickel-palladium alloy plating layer, in which a lot of nickel is contained inside and a lot of palladium is contained outside, can be formed by a method in which a ratio of nickel sulfate:palladium sulfate is set so that the liquid is made rich in nickel sulfate at an initial stage of a plating step and the liquid is made rich in palladium sulfate just before a completion of the dropwise addition.

The gold plating layer or palladium plating layer 6b can be formed by a displacement gold plating or displacement palladium plating. Conduction characteristics can be further enhanced by providing the gold plating layer or palladium plating layer 6b.

In the anisotropically conductive adhesive for COG, an insulation reliability at narrow pitches of about 10 µm is recently required. Thus, in order to further enhance insulation reliability, it is effective to coat the composite conductive particle 3 comprising the nickel-palladium alloy plating layer with the insulating fine particles 1.

The insulating fine particles 1 are preferably inorganic oxide particles. An organic particle readily deforms in the process of manufacturing an anisotropically conductive adhesive and to be changed in the characteristics.

The inorganic oxide particle preferably contains an oxide containing at least one selected from the group consisting of silicon, aluminum, zirconium, titanium, niobium, zinc, tin, cerium and magnesium. Among the oxides, a silica particle provided as water-dispersed colloidal silica (SiO₂) having a controlled particle diameter is preferable because of good insulation properties. Because the silica particle in the water-dispersed colloidal silica (SiO₂) has a hydroxyl group on a surface thereof, the water-dispersed colloidal silica is preferable in terms of its good bonding properties with the conductive particle 3, its particle diameter that is easily controllable, and its economical advantage. Examples of marketed products of the water-dispersed colloidal silica include, for example, SNOWTEX and SNOWTEX UP (available from Nissan Chemical Industries, Ltd.) and Quartron PL series (available from Fuso Chemical Co., Ltd.). In point of insulation reliability, it is desired that the concentration of alkali metal ions and alkaline earth metals ions in a dispersion solution is 100 ppm or less, and preferably an inorganic oxide fine particle prepared by a hydrolytic reaction of a metal alkoxide, so called a sol-gel process, is suitable.

The particle diameter of the insulating fine particles, which is measured by a specific surface area reduction method by the BET method or by a small angle X-ray scattering method, is preferably 20 to 500 nun. If the insulating fine particles are small, the insulating fine particles adsorbed on the composite conductive particle 3 do not sufficiently act as an insulating film, which tends to partly cause a short circuit. By contrast, if the particle diameter of the insulating fine particles is large, a conductivity of an electrode connected tends to be decreased. After preparing the composite conductive particle, the particle diameter of the insulating fine particles on the surface of the composite conductive particle can be measured by SEM. Meanwhile, for a composite conductive particle present in the anisotropically conductive adhesive film, the particle diameter of the insulating fine particles can be measured by SEM after dissolving and removing an adhesive composition with a solvent.

The hydroxyl group on the surface of the inorganic oxide particle can be denatured to an amino group, a carboxyl group, or an epoxy group with a silane coupling agent or the like. However, if the particle diameter of the inorganic oxide particle is 500 nm or smaller, the denaturation is usually difficult to perform.

A hydroxyl group is generally known to form a strong bond with a hydroxyl group, a carboxyl group, an alkoxyl group and an alkoxycarbonyl group. Specific manners of the bond between the hydroxyl group and these functional groups include a covalent bond by dehydration condensation or a hydrogen bond. Accordingly, it is preferred that these functional groups are formed on the surface of the composite conductive particle 3.

It is preferred that a functional group selected from a hydroxyl group, a carboxyl group, an alkoxyl group and an alkoxycarbonyl group is introduced on the surface of the composite conductive particle 3 by treating the metal-layer surface of the composite conductive particle 3 by using a compound having a mercapto group, a sulfide group or a disulfide group, which forms a coordinate bond with gold or palladium, and a hydroxyl group, a carboxyl group, an alkoxyl group or an alkoxycarbonyl group. The compounds used can include mercaptoacetic acid, 2-mercaptoethanol, methyl mercaptoacetate, mercaptosuccinic acid, thioglycerin, cysteine, and the like.

A noble metal such as palladium readily reacts with thiol, and a base metal such as nickel is difficult to react with thiol. Accordingly, it is preferred that palladium exists in amount of 50 mol% or more on the surface of the composite conductive particle 3.

Specific methods for treating the surface of the metal layer with the compound described above are not limited, but include a method in which the compound such as mercaptoacetic acid is dispersed at a concentration of approximately from 10 to 100 mmol/L in an organic solvent such as methanol and ethanol, and the composite conductive particle having the metal surface is dispersed thereinto.

The coated conductive particle 5 may further comprise a polymer electrolyte layer provided between the composite conductive particle 3 and the insulating fine particles 1. In this instance, the insulating fine particles 1 coat a part of the surface of the metal layer 6 so that the polymer electrolyte layer is sandwiched therebetween.

The surface potential (zeta potential) of a particle having, on a surface thereof, a functional group such as a hydroxyl group, a carboxyl group, an alkoxyl group or an alkoxycarbonyl group is generally negative at a neutral pH range. On the other hand, the surface potential of an inorganic oxide particle having a hydroxyl group is also negative. In many cases, it is difficult to sufficiently coat a surface of the particle having a negative surface potential with the particle having a negative surface potential, but the insulating fine particles can be effectively adhered to the composite conductive particle by providing the polymer electrolyte layer therebetween. Further, the providing of the polymer electrolyte layer allows the insulating fine particles to uniformly coat the surface of the composite conductive particle with no defects, thereby resulting in that insulating properties are secured even in narrower pitches of a circuit electrode interval and an effect that a connection resistance becomes to be lowered between electrodes electrically connected is further remarkably exhibited.

As for the polymer electrolyte forming the polymer electrolyte layer, a high molecule that has a functional group ionizing in an aqueous solution and having an electrical charge on its main chain or its side chain can be used, and polycation is preferable. Polycation having a functional group that can have a positive charge, such as polyamines, can be used generally, which includes polyethyleneimine (PEI), polyallylamine hydrochloride (PAH), polydiallyldimethylammonium chloride (PDDA), polyvinylpyridine (PVP), polylysine, polyacrylamide and a copolymer containing at least one type thereof, for example. Among the polymer electrolyte, polyethyleneimine has high charge density and high bonding strength.

To prevent electromigration and corrosion, it is preferred that the polymer electrolyte layer contains substantially no alkali metal (Li, Na, K, Rb and Cs) ions, no alkaline-earth metal (Ca, Sr, Ba and Ra) ions or no halide ions (fluorine ion, chloride ion, bromine ion and iodine ion).

The above polymer electrolytes are soluble in water and a mixture of water and an organic solvent. The molecular weight of the polymer electrolyte, which cannot be generally specified depending on the type of the polymer electrolyte to be used, is preferably about 500 to 200,000 generally.

By adjusting the type and molecular weight of the polymer electrolyte, the coverage of the composite conductive particle with the insulating fine particles can be controlled. More specifically, in the case where a polymer electrolyte with high charge density, such as polyethyleneimine, is used, the coverage with the insulating fine particles tends to be high, whereas in the case where a polymer electrolyte with low charge density, such as poly diallyldimethylammonium chloride, is used, the coverage with the insulating fine particles tends to be low. In the meanwhile, in the case where the molecular weight of the polymer electrolyte is large, the coverage with the insulating fine particles tends to be high, while, in the case where the molecular weight of the polymer electrolyte is small, the coverage with the insulating fine particles tends to be low.

The coated conductive particle 5 can be produced by, for example, a method comprising a step of forming the metal layer 7 coating the resin particle 4 and obtaining the composite conductive particle comprising the resin particle and the metal layer coating the resin particle, a step of forming the polymer electrolyte layer on the metal layer, and a step of providing the insulating fine particles on the outer side of the composite conductive particle so that the polymer electrolyte layer is sandwiched therebetween.

The composite conductive particle comprising the metal layer can be treated with a compound having a mercapto group, a sulfide group or a disulfide group to introduce a functional group on the surface of the metal layer. For example, a functional group selected from a hydroxyl group, a carboxyl group, an alkoxyl group and an alkoxycarbonyl group is introduced on the surface of the metal layer by adding the composite conductive particle to a reaction liquid containing at least one compound selected from mercaptoacetic acid, 2-mercaptoethanol, methyl mercaptoacetate, mercaptosuccinic acid, thioglycerin and cysteine and reacting the metal surface of the composite conductive particle with these compounds.

By dispersing the composite conductive particle having these functional groups into a polymer electrolyte solution, the polymer electrolyte can be adsorbed onto the surface of the metal layer to form the polymer electrolyte layer. After the composite conductive particle comprising the polymer electrolyte layer formed thereon is taken out from the polymer electrolyte solution, it is preferred that the excessive polymer electrolyte is removed by rinsing. The rinsing is conducted, for example, by using water, alcohol or acetone. Ion exchange water (so-called super pure water) having a specific resistance value of 18 MΩ·cm or more is preferably used. Because the polymer electrolyte adsorbed on the composite conductive particle is electrostatically adsorbed on the surface of the composite conductive particle, the polymer electrolyte is not separated in this rinsing step.

The polymer electrolyte solution is a solution prepared by dissolving a polymer electrolyte in water or a mixed solvent of water and a water-soluble organic solvent. Applicable water-soluble organic solvents include, for example, methanol, ethanol, propanol, acetone, dimethylformamide and acetonitrile.

The concentration of the polymer electrolyte in the polymer electrolyte solution is preferably about 0.01 to 10% by mass generally. The pH of the polymer electrolyte solution is not particularly restricted. In the case where the polymer electrolyte is used in a high concentration, the coverage of the composite conductive particle with the insulating fine particles tends to be high, whereas in the case where the polymer electrolyte is used in a low concentration, the coverage of the composite conductive particle with the insulating fine particles tends to be low.

By dispersing the composite conductive particle comprising the polymer electrolyte layer formed thereon into a dispersed solution containing the insulating fine particles, the insulating fine particles can be adsorbed onto the composite conductive particle via the polymer electrolyte layer. By providing the polymer electrolyte layer, the insulating fine particles are adsorbed by electrostatic attraction. When the adsorption proceeds to cause a charge neutralization, a further adsorption does not occur. Therefore, if the reaction reaches a certain saturation point, the thickness of the film does not substantially increase any more.

After the adsorption of the insulating fine particles, it is preferred that the excessive insulating fine particles are removed by rinsing from the coated conductive particle taken out from the dispersed solution. The rinsing is conducted, for example, by using water, alcohol or acetone. Ion exchange water (so-called super pure water) having a specific resistance value of 18 MΩ·cm or more is preferably used. Because the insulating fine particles adsorbed on the composite conductive particle are electrostatically adsorbed on the surface of the composite conductive particle, the insulating fine particles are not detached in this rinsing step.

It can be avoided for the excessive polymer electrolyte or insulating fine particles to be brought into the next step by conducting the rinsing step after formation of the polymer electrolyte layer and adsorption of the insulating fine particles. In a case where the rinsing step is not conducted, cations and anions can be mixed together in the solution, and aggregation and precipitation of the polymer electrolyte and the insulating fine particles may occur.

The coated conductive particle thus obtained can be dried with heating. Thus, the bond between the insulating fine particles and the composite conductive particle can be further enhanced. Reasons for the enhancement of the bonding strength include, for example, a chemical bond between a functional group, such as a carboxyl group, introduced in the surface of the metal layer and a hydroxyl group on the particle surface of the insulating fine particles. The temperature of heating is preferably from 60 to 200°C, and a heating period of time is preferably 10 to 180 minutes. In the case where the heating temperature is lower than 60°C or the heating period of time is shorter than 10 minutes, the insulating fine particles are likely to be separated. In the case where the temperature of heating exceeds 200°C or the heating period of time is longer than 180 minutes, the composite conductive particle can be deformed.

The coated conductive particle can have a hydrophobicity by treating it with a hydrophobic silane coupling agent or silicone oligomer and the like.

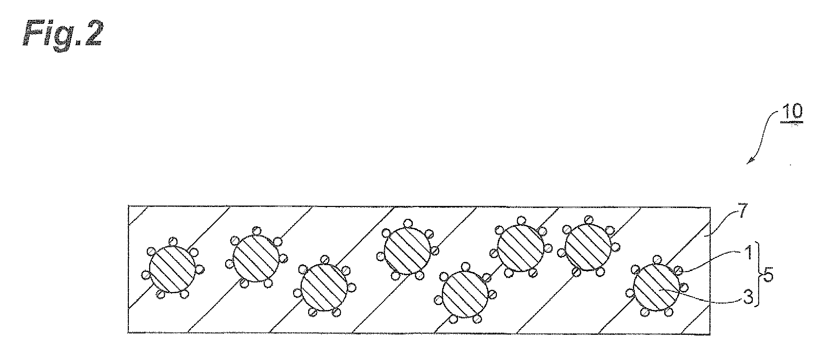

Figure 2 is a cross-sectional view showing one embodiment of the anisotropically conductive adhesive. The anisotropically conductive adhesive 10 shown in Figure 2 contains an insulating adhesive 7 in a film form and a plurality of coated conductive particles 5 dispersed into the insulating adhesive 7.

The insulating adhesive 7 contains a thermosetting resin and a curing agent therefor. The insulating adhesive 7 can contain a radical reactive resin as the thermosetting resin and an organic peroxide as the curing agent, and can be an energy-ray curable resin cured by ultraviolet ray or the like.

The thermosetting resin constituting the insulating adhesive 7 is preferably an epoxy resin, and a mixture thereof with a latent curing agent is preferably used.

The latent curing agent can include imidazole, hydrazide, boron trifluoride-amine complex, sulfonium salt, aminimide, polyamine salt, dicyandiamide and the like.

The epoxy resin used can include a bisphenol type epoxy resin induced from epichlorohydrin and bisphenol-A, F, AD or the like, an epoxy novolac resin induced from epichlorohydrin and phenol novolac or cresol novolac, a naphthalene based epoxy resin with a skeleton containing a naphthalene ring, and various types of epoxy compounds of glycidyl amine, glycidyl ether, biphenyl, and alicyclic having two or more glycidyl groups in one molecule or the like, and they can be used alone or in combination of two or more compounds.

The high-purity epoxy resin, in which an impurity ion (e.g., Na⁺, Cl⁻) and a hydrolyzable chlorine or the like is reduced to 300 ppm or less, is preferably used for preventing an electromigration.

In order to decrease a stress after being adhered or to enhance an adhesiveness, the insulating adhesive 7 can contain a butadiene rubber, an acrylic rubber, a styrene-butadiene rubber, a silicone rubber, or the like.

In order to make the insulating adhesive 7 in a film form, it is effective to mix a thermoplastic resin, such as a phenoxy resin, a polyester resin and a polyamide resin, as a film formable polymer to the insulating adhesive 7. These thermoplastic resins are also effective for a stress relaxation in curing the thermoplastic resin. Particularly, it is preferred that the film formable polymer has a functional group such as a hydroxyl group in order to enhance an adhesiveness.

The thickness of the insulating adhesive 7 is suitably determined in consideration of the particle diameter of the coated conductive particle 5 and characteristics of the anisotropically conductive adhesive 10, but is preferably 1 to 100 µm. If the thickness is smaller than 1 µm, an adhesiveness tends to be lowered, whereas if it exceeds 100 µm, a lot of coated conductive particles tend to be required to obtain a conductivity. From the same point of view, the thickness of the insulating adhesive 7 is more preferably 3 to 50 µm.

The anisotropically conductive adhesive 10 in a film form can be obtained by, for example, a method comprising a step of applying a liquid composition containing an insulating adhesive, an insulating coated conductive particle, and an organic solvent for dissolving or dispersing them on a release base material and a step of removing the organic solvent from the applied liquid composition at or below an activation temperature of the curing agent. A mixture of an aromatic hydrocarbon solvent and an oxygenated solvent is preferably used for the organic solvent in this process for enhancing a solubility of the materials.

The anisotropically conductive adhesive is not necessarily in a film form as in the present embodiment, and can be, for example, in a paste form.

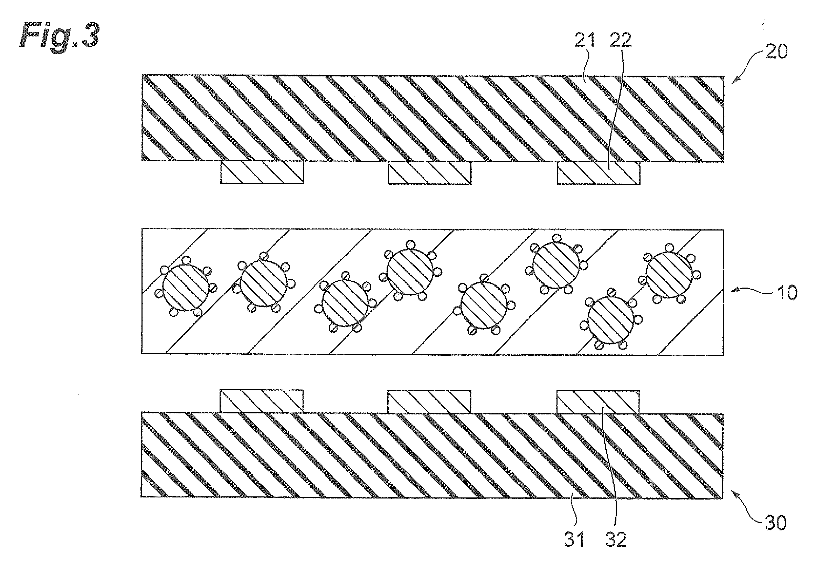

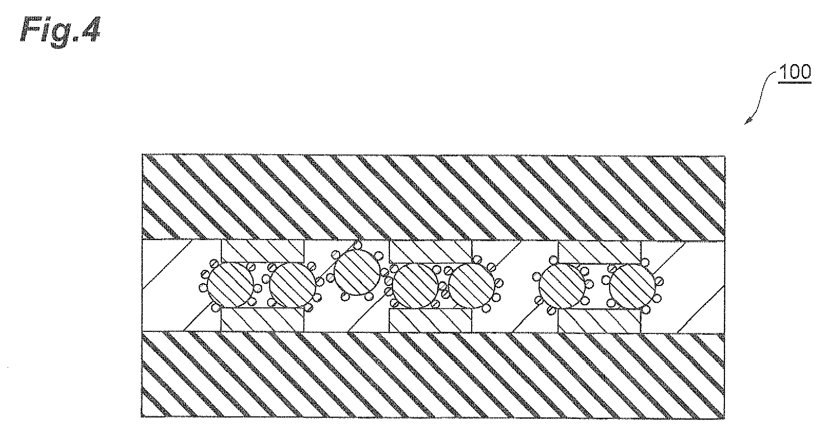

Figure 3 is a cross-sectional view showing one embodiment of a circuit connection method by the anisotropically conductive adhesive. As illustrated in Figure 3, a first circuit member 20 having a substrate 21 and an electrode 22 provided on the substrate and a second circuit member 30 having a substrate 31 and an electrode 32 provided on the substrate 31 are provided to face each other so that the electrode 22 and the electrode 32 face each other, and the anisotropically conductive adhesive 10 is provided between the first circuit member 20 and the second circuit member 30. By heating and pressurizing a whole in such a state, a connection structure 100, in which the first circuit member 20 and the second circuit member 30 are circuit connected, is obtained as illustrated in the cross-sectional view of Figure 4.

These circuit members include a glass substrate, a tape substrate such as polyimide, a bare chip such as a driver IC, and a rigid package substrate, and the like.

In the connection structure 100 obtained, the insulating fine particles are peeled off in contacting parts of the insulating coated conductive particle with the electrodes, which causes the electrodes facing each other to be electrically conductive. In the meanwhile, an electrical insulation is maintained between adjacent electrodes on an identical substrate due to the insulating fine particles provided therebetween.

### Examples

The present invention will be further described in detail with Examples below. However, the present invention is not limited to the Examples.

### (Example 1)

### (1) Preparation of a composite conductive particle

One hundred grams of resin particles (cross-linked polystyrene particles) having an average particle diameter of 3.8 µm were added to 100 mL of a palladium catalyst solution containing Atotech Neoganth 834 (available from Atotech Japan Co., Ltd., brand name), which is a palladium catalyst, in an amount of 8% by mass, and stirred at 30°C for 30 minutes. Then, the mixture was filtered out by a membrane filter having φ (pore diameter) of 3 µm (available from Millipore Corporation), and then washed with water. The resin particles washed with water were added to a 0.5% by mass dimethylamine-borane solution having an adjusted pH of 6.0, and resin particles with activated surfaces were prepared.

Next, the resin particles with an activated surface were dispersed in 200mL of 0.2% ammonia aqueous solution and the mixture was heated to 65 °C. Next, electroless plating solutions (dropping liquid A and dropping liquid B) shown in Example 1 of Table 1 were dropwise added thereto at a dropping speed of 50 mL/minute for each solution to form a plating layer having a thickness of 500 Å. A ratio of palladium and nickel of the plating layer measured by an atomic absorption method was approximately similar to a ratio of metal ions dropwise added.

Subsequently, the particles were filtered out by a membrane filter having φ of 3 µm (available from Millipore Corporation), washed with water, and then dried, and thus composite conductive particles 1 having a nickel-palladium alloy plating layer having a thickness of 500 Å formed on the outer side of the resin particles as core particles were produced. Particle appearance was good after plating.

A reaction solution was prepared by dissolving 8 mmol of mercaptoacetic acid in 200 ml of methanol. One gram of the composite conductive particles 1 was then added to the reaction solution, and stirred at room temperature for 2 hours by a three-one motor and stirring blades with a diameter of 45 mm. The composite conductive particles filtered out by a membrane filter having φ of 3 µm (available from Millipore Corporation) were washed with methanol, and thus 1 g of composite conductive particles having a carboxyl group on a surface thereof were obtained.

Thirty-percent polyethyleneimine aqueous solution with a molecular weight of 70000 (available from Wako Pure Chemical Industries, Ltd.) was diluted with super pure water to prepare a 0.3% by mass polyethyleneimine aqueous solution. One gram of the composite conductive particles having a carboxyl group on a surface thereof was added thereto and stirred at room temperature for 15 minutes. Then, the composite conductive particles were then filtered out by a membrane filter having φ of 3 µm (available from Millipore Corporation), and the composite conductive particles filtered out were added to 200 g of super pure water, and stirred at room temperature for 5 minutes. Additionally, the composite conductive particles were further filtered out by a membrane filter having φ of 3 µm (available from Millipore Corporation), and the composite conductive particles were washed with 200 g of super pure water on the membrane filter twice, and thus polyethyleneimine not being adsorbed on the composite conductive particles was removed.

A dispersed solution of colloidal silica (mass concentration of 20%, available from Fuso Chemical Co., Ltd., brand name: Quartron PL-10, average particle diameter of 100 nm) was diluted with super pure water to prepare a 0.1% by mass silica particles dispersed solution. The composite conductive particles treated with polyethyleneimine were added thereto, and stirred at room temperature for 15 minutes. Coated conductive particles were filtered out by a membrane filter having φ of 3 µm (available from Millipore Corporation), and the coated conductive particles thus filtered out were added to 200 g of super pure water and stirred at room temperature for 5 minutes. The coated conductive particles were further filtered out by a membrane filter having φ of 3 µm (available from Millipore Corporation), and the coated conductive particles were washed with 200 g of super pure water on the membrane filter twice, and thus silica particles not being adsorbed on the coated conductive particles were removed. The coated conductive particles were then dried by heating at 80°C for 30 minutes and then at 120°C for 1 hour, and thus coated conductive particles 1 coated with silica particles were produced.

### (2) Preparation of an anisotropically conductive adhesive film and a circuit connection using it

One hundred grams of a phenoxy resin (available from Union Carbide Corporation, brand name: PKHC) and 75 g of an acrylic rubber (a copolymer of 40 parts by mass of butyl acrylate, 30 parts by mass of ethyl acrylate, 30 parts by mass of acrylonitrile, and 3 parts by mass of glycidyl methacrylate, molecular weight: 850,000) were dissolved in 400 g of ethyl acetate to prepare a 30% by mass solution. Next, 300 g of a liquid epoxy resin (epoxy equivalent of 185, available from Asahi Kasei Epoxy Co., Ltd., brand name: Novacure HX-3941) containing a microcapsule-type latent curing agent was added to the solution and stirred, whereby an adhesive solution was produced.

The coated conductive particles 1 were dispersed in the adhesive solution. A concentration thereof was 9% by volume on the basis of an amount of the adhesive solution. The resulting dispersed solution was applied to a separator (a polyethylene terephthalate film treated with silicone, with a thickness of 40 µm) with a roll coater, dried by heating at 90°C for 10 minutes, whereby an anisotropically conductive film with a thickness of 25 µm was formed on the separator.

Next, by using the produced anisotropically conductive adhesive film, a connection of a chip (1.7 × 1.7 mm, thickness: 0.5 µm) including gold bumps (area: 30 × 90 µ m, space: 10 µm, height: 15 µ m, the number of bumps: 362) to a glass substrate (thickness: 0.7 mm) with an Al circuit was performed by the following procedures i) to iii).
i) The anisotropically conductive film (2 × 19 mm) was attached to the glass substrate with the Al circuit at 80°C and at a pressure of 0.98 MPa (10 kgf/cm²).
ii) The separator was peeled therefrom, and the bumps of the chip and the glass substrate with the Al circuit were aligned.
iii) By applying heat and pressure from above the chip under conditions of 190°C, 40 gf/bump, and 10 seconds, an actual connection was performed.

### (Example 2)

Composite conductive particles 2 having a nickel-palladium alloy plating layer having a thickness of 500 Å were produced in the same manner as that in Example 1 except for using an electroless plating solution shown at Example 2 of Table 1. Particle appearance was good after plating. Next, silica particles were adhered to the composite conductive particles 2, and coated conductive particles 2 coated with silica particles were produced, and further a preparation of an anisotropically conductive adhesive film and a circuit connection using it were preformed, in the same manner as that in Example 1.

### (Example 3)

Composite conductive particles 3 having a nickel-palladium alloy plating layer having a thickness of 500 Å were produced in the same manner as that in Example 1 except for using an electroless plating solution shown at Example 3 of Table 1. Particle appearance was generally good after plating, but a partial peeling occurred. Next, silica particles were adhered to the composite conductive particles 3, and coated conductive particles 3 coated with silica particles were produced, and further a preparation of an anisotropically conductive adhesive film and a circuit connection using it were preformed, in the same manner as that in Example 1.

### (Example 4)

Electroless plating solutions shown Example 4 (1) of Table 1 were dropwise added at a dropping speed of 50 mL/minute to form a nickel-palladium alloy plating layer having a thickness of 250 Å on the resin particles with activated surfaces. Continuously, electroless plating solutions shown Example 4 (2) of Table 1 were dropwise added thereto at a dropping speed of 50 mL/minute of each solution to further form a nickel-palladium alloy plating layer having a thickness of 250 Å. Composite conductive particles 4 were produced in the same manner as that in Example 1 except for the above. Particle appearance was good after plating. Next, silica particles were adhered to the composite conductive particles 4, and coated conductive particles 4 coated with silica particles were produced, and further a preparation of an anisotropically conductive adhesive film and a circuit connection using it were preformed, in the same manner as that in Example 1.

### (Comparative Example 1)

Composite conductive particles 5 comprising a nickel plating layer having a thickness of 500 Å on the resin particles with activated surfaces were produced in the same manner as that in Example 1 except for using an electroless plating solution shown at Comparative Example 1 of Table 2. Particle appearance was good after plating. Next, silica particles were adhered to the composite conductive particles 5, and coated conductive particles 5 coated with silica particles were produced, and further a preparation of an anisotropically conductive adhesive film and a circuit connection using it were preformed, in the same manner as that in Example 1.

### (Comparative Example 2)

Composite conductive particles 6 comprising a palladium plating layer having a thickness of 500 Å were produced by performing a dropwise addition at a dropping speed of 50 mL/minute in the same manner as that in Example 1 except for using an electroless plating solution shown at Comparative Example 2 of Table 2. However, a lot of plating peeling occurred, and therefore it was difficult to proceed to the next step.

**[Table 1]**

| Electroless plating solution | | Example 1 | Example 2 | Example 3 | Example 4 (1) | Example 4 (2) |
|---|---|---|---|---|---|---|
| Dropping liquid A | Nickel sulfate | 0.5 Mol/l | 0.9 Mol/l | 0.1 Mol/l | 0.9 Mol/l | 0.1 Mol/l |
| | Palladium sulfate | 0.5 Mol/l | 0.1 Mol/l | 0.9 Mol/l | 0.1 Mol/l | 0.9 Mol/l |
| | Ammonia water (28%) | 2 Mol/l | 2 Mol/l | 2 Mol/l | 2 Mol/l | 2 Mol/l |
| Dropping liquid B | Sodium hypophosphite | 2 Mol/l | 2 Mol/l | 2 Mol/l | 2 Mol/l | 2 Mol/l |
| | Sodium hydroxide | 2 Mol/l | 2 Mol/l | 2 Mol/l | 2 Mol/l | 2 Mol/l |
| Appearance after plating | | Good | Good | Partial peeling | Good | Good |

**[Table 2]**

| Electroless plating solution | | Comparative Examples 1 | Comparative Examples 2 |
|---|---|---|---|
| Dropping liquid A | Nickel sulfate | 1 Mol/l | 0 Mol/l |
| | Palladium sulfate | 0 Mol/l | 1 Mol/l |
| | Ammonia water (28%) | 2 Mol/l | 2 Mol/l |
| Dropping liquid B | Sodium hypophosphite | 2 Mol/l | 2 Mol/l |
| | Sodium hydroxide | 2 Mol/l | 2 Mo/l |
| Appearance after plating | | Good | Peeling |

### Examination of silica particles coverage

The coverage of the composite conductive particles with silica particles was confirmed by analyzing the images by using SEM. The coverage was determined by drawing, on a SEM image, a circle having a diameter being half of a diameter of the composite conductive particle, measuring a projected area of silica particles and the number thereof within the circle, and using the equation : the coverage = (the projected area of silica particles × the number of silica particles) / (an area of a range measured). The coverage was measured from 25 sheets of SEM images, the variation of the coverage was determined from the equation : C.V = (standard deviation / average coverage). In a case of this series, the coverage of about 50% is the most suitable and a smaller variation of the coverage is desired.

### Insulation Resistance Test and Conductive Resistance Test

Insulation resistance tests and conductive resistance tests were performed for the samples produced in Examples and Comparative Examples. It is important for an anisotropically conductive adhesive film to provide a high insulation resistance between chip electrodes and a low conductive resistance between chip electrodes and glass electrodes. Insulation resistances between chip electrodes (10 µm) of 20 samples were measured, and the minimum value thereof was determined. The insulation resistance was represented by measuring the value after performing a reliability test by leaving to stand for 250 hours under the conditions of an ambient temperature of 60°C, a humidity of 90%, and an application DC voltage of 20 V. Yields of samples having an insulation resistance of 10⁹ Ω or more were calculated as good items. Additionally, for the conductive resistance between chip electrodes and glass electrodes, the average value of 14 samples was measured. The conductive resistance was represented by measuring the initial value and the value after performing a reliability test (a moisture absorption and heat resistance test) by leaving to stand for 1000 hours under the conditions of an ambient temperature of 85 °C and a humidity of 85%.

**[Table 3]**

| | Plating layer | | Silica particles coverage | | Moulting reliability | | | |
|---|---|---|---|---|---|---|---|---|
| | | | | | Insulation resistance | | Conductive resistance | |
| | Composition | Thickness (Å) | Coverage | Variation (C.V.) | Minimum value (Ω) | Yield | Initial value (Ω) | After moisture absorption test (Ω) |
| Example 1 | Nickel-palladium alloy | 500 | 52% | 0.15 | 10⁹ or more | 100% | 0.5 | 15 or less |
| Example 2 | Nickel-palladium alloy | 500 | 43% | 0.32 | 10⁵ or less | 85% | 1.2 | 19 or less |
| Example 3 | Nickel-palladium alloy | 500 | 51% | 0.11 | 10⁹ or more | 100% | 0.4 | 9 or less |
| Example 4 | Nickel-paiiadium alloy | 250/250 | 52% | 0.11 | 10⁹ or more | 100% | 0.4 | 10 or less |
| Comparative Example 1 | Nickel | 500 | 37% | 1.3 | 10⁵ or less | 0% | 1.5 | 25 |
| Comparative Example 2 | palladium | 500 | - | - | - | - | - | - |

The measured results are shown at Table 3. In a case of Comparative Example 2, coated conductive particles per se were not able to be produced, and thus evaluations were not able to be performed. According to the samples of respective Examples, insulation resistances and conductive resistances were obtained and high moisture absorption resistances were exhibited. Examples 1, 3 and 4 are stable in the coverage and thus have a merit of being easily produced. By contrast, it was found that, in the sample of Comparative Example 1 having only a nickel plating layer provided, the insulating fine particles are not stably adsorbed and reliability is poor. Conduction characteristics are the best at Examples 3 and 4 and are lowered in the order of Example 1, Example 2, and Comparative Example 1. That is, it is shown that the larger the ratio of palladium on the surface of the composite conductive particle is, the better the conduction reliability is.

### Reference Signs List

1 ... insulating fine particle, 3 ... composite conductive particle, 4 ... resin particle, 5 ... coated conductive particle, 6 ... metal layer, 6a ... nickel-palladium alloy plating layer, 6b ... gold plating layer or palladium plating layer, 7 ... insulating adhesive, 10 ... anisotropically conductive adhesive, 20 ... first circuit member, 21 ... substrate, 22 ... electrode, 30 ... second circuit member, 31 ... substrate, 32 ... electrode, 100 ... connection structure.

## Claims

1. A coated conductive particle comprising:
a composite conductive particle comprising a resin particle and a metal layer coating the resin particle; and
insulating fine particles provided on the outer side of the metal layer and coating a part of a surface of the metal layer,
wherein the metal layer comprises a nickel-palladium alloy plating layer.

2. The coated conductive particle according to claim 1, wherein a molar ratio of nickel:palladium in the nickel-palladium alloy plating layer is 1:99 to 99: 1.

3. The coated conductive particle according to claim 1 or 2, wherein the nickel-palladium alloy plating layer is comprised of a plurality of layers having different palladium ratios from each other, and an outermost layer in the plurality of layers has the most amount of palladium.

4. The coated conductive particle according to any one of claims 1 to 3, wherein the metal layer further comprises a gold plating layer or palladium plating layer provided on the outer side of the nickel-palladium alloy plating layer, and the insulating fine particles are provided on the outer side of the gold plating layer or the palladium plating layer.

5. The coated conductive particle according to any one of claims 1 to 4, wherein the insulating fine particles dent into the metal layer when an anisotropically conductive adhesive film containing the coated conductive particle is pressure bonded.

6. The coated conductive particle according to claim 4 or 5, wherein the gold plating layer or the palladium plating layer is a reduction plating type layer positioned at the outermost layer of the metal layer.

7. The coated conductive particle according to any one of claims 1 to 6, wherein the nickel-palladium alloy plating layer contains boron or phosphorus.

8. A method for producing a coated conductive particle, the method comprising the steps of:
treating a composite conductive particle comprising a resin particle and a metal layer coating the resin particle, the metal layer comprising a nickel-palladium alloy plating layer, with a compound having a mercapto group, a sulfide group or a disulfide group to introduce a functional group on a surface of the metal layer; and
providing insulating fine particles coating a part of the surface of the metal layer, on the outer side of the composite conductive particle.

9. A method for producing a coated conductive particle, the method comprising the steps of:
treating a composite conductive particle comprising a resin particle and a metal layer coating the resin particle, the metal layer comprising a nickel-palladium alloy plating layer, with a compound having a mercapto group, a sulfide group or a disulfide group to introduce a functional group in a surface of the metal layer;
forming a polymer electrolyte layer on the metal layer; and
providing insulating fine particles coating a part of a surface of the metal layer, on the outer side of the composite conductive particle so that the polymer electrolyte layer is sandwiched therebetween.

10. The method according to claim 9, wherein the functional group introduced on the surface of the metal layer is at least one selected from the group consisting of a hydroxyl group, a carboxyl group, an alkoxyl group and an alkoxycarbonyl group.

11. The method according to claim 9 or 10, wherein the polymer electrolyte layer is formed from polyamine.

12. The method according to claim 11, wherein the polyamine is polyethyleneimine.

13. The method according to any one of claims 8 to 12, wherein the insulating fine particles are inorganic oxide particles.

14. The method according to claim 13, wherein the inorganic oxide particles are silica particles.
